# EUROPEAN PATENT APPLICATION

(11) **EP 4 790 167 A1**
(43) Date of publication of application: **12.08.2026**
(21) Application number: 25839245.5
(22) Date of filing: 14.07.2025
(51) Int. Cl.: C23C 16/27, C23C 16/52

(54) **HOT FILAMENT STRUCTURE, AND DEVICE AND METHOD FOR AUTOMATICALLY CONTROLLING FILAMENT SPACING FOR DIAMOND DEPOSITION**

(30) Priority: 06.12.2024 CN 202411786474
(71) Applicant: Sinoma Synthetic Crystals (Shandong) Co., Ltd., Jinan, Shandong 250215 (CN); China National Building Material Group Co., Ltd., Beijing 100036 (CN)
(72) Inventor: ZHAO, Xiaobo, Jinan, Shandong 250215 (CN); WEI, Huayang, Jinan, Shandong 250215 (CN); WANG, Yubao, Jinan, Shandong 250215 (CN); LI, Rongzhen, Jinan, Shandong 250215 (CN); DONG, Xinbao, Jinan, Shandong 250215 (CN); LIU, Mingzhao, Jinan, Shandong 250215 (CN); CAO, Yanxin, Jinan, Shandong 250215 (CN); WANG, Xiaoling, Jinan, Shandong 250215 (CN)
(74) Representative: INNOV-GROUP
(86) International application number: PCT/CN2025/108365
(87) International publication number: WO 2026/118456

(57) **Abstract**

Embodiments of the present application provide a hot filament structure, an apparatus and a method for depositing diamond with automatic control of distance between filaments. The hot filament structure comprises: a plurality of hot filaments, a support assembly, and at least one adjustment mechanism. The support assembly comprises a first metal rod and a second metal rod arranged opposite along an extension direction of the hot filaments, and a plurality of first metal blocks slidably arranged at the first metal rod, and a plurality of second metal blocks slidably arranged at the second metal rod, one end of each hot filament is connected to a first metal block, and the other end of the hot filament is connected to a second metal block. The adjustment mechanism is connected to the first metal blocks and the second metal blocks to adjust a distance between adjacent hot filaments. The hot filament structure can solve the problem of uneven size of the grain as the deposition time and film thickness increase.

## Description

This application claims the priority of the Chinese patent application filed with the Patent Office of the China National Intellectual Property Administration on December 06, 2024, with the application number 202411786474.3 and the invention title "Hot Filament Structure, Apparatus and Method for Depositing Diamond with Automatic Control of Distance Between Filaments", the entire content of which is incorporated herein by reference.

### Technical Field

The present application relates to the technical field of hot filament chemical vapor deposition, in particular to a hot filament structure, an apparatus and a method for depositing diamond with automatic control of distance between filaments.

### Background

Hot Filament Chemical Vapor Deposition (HFCVD) is a process in which high-temperature hot filaments (tungsten filaments, tantalum filaments) is used to dissociate and excite deposition gas into a large number of particles, which are then deposited onto the substrate surface through chemical reactions. Hot Filament Chemical Vapor Deposition is a technology for preparing diamond films, which has the advantages of high deposition rate, high quality of deposited films, and wide applicability. Therefore, the temperature of the hot filament and the temperature of the substrate surface are key factors for determining the deposition rate and deposition quality of diamond. At present, in the process of preparing diamond films by hot filament chemical vapor deposition equipment, as the diamond film thickens, the distance between the hot filaments and the film gradually decreases, the nucleation rate decreases, and the growth rate increases, resulting in the grain size of the diamond film gradually increasing with the increase of deposition time and film thickness, that is, the grain sizes varies at different positions of the same diamond film, which affects the quality of the diamond film.

### Summary

The purpose of the embodiments of the present application is to provide a hot filament structure, an apparatus and a method for depositing diamond with automatic control of distance between filaments, to solve the problem that the grain size gradually becomes larger with the increase of deposition time and film thickness. The specific technical solutions are as follows:
The first aspect of the present application provides a hot filament structure, comprising: a plurality of hot filaments; a support assembly, comprising a first metal rod and a second metal rod arranged opposite to each other along an extension direction of the hot filaments, a plurality of first metal blocks slidably arranged at the first metal rod, and a plurality of second metal blocks slidably arranged at the second metal rod, one end of each hot filament is connected to a first metal block, and the other end of the hot filament is connected to a second metal block; at least one adjustment mechanism connected to the first metal blocks and the second metal blocks to adjust a distance between adjacent hot filaments.

In some embodiments, the hot filament structure comprises two adjustment mechanisms arranged at intervals along the extension direction of the hot filaments, and respectively arranged at outer sides of the first metal rod and the second metal rod, and the adjustment mechanisms are respectively connected to the first metal blocks and the second metal blocks.

In some embodiments, the adjustment mechanism comprises: a drive assembly; a movable member provided with a plurality of sliding channels, one end of the movable member being connected to the drive assembly; a plurality of connecting members, corresponding one-to-one to the sliding channels, and one end of each connecting member being inserted into a sliding channel, the other end of the connecting member being respectively connected to a first metal block or a second metal block; the drive assembly is configured for driving the movable member to move along a first direction, such that the movable member slides relative to the connecting members along the sliding channels, thus the connecting members can be driven to move along a second direction to drive the hot filaments to move along the second direction, wherein the first direction is parallel to the extension direction of the hot filaments, and the second direction is co-planar with and perpendicular to the first direction.

In some embodiments, the sliding channels extend through or do not extend through the movable member along a thickness direction of the movable member, and the thickness direction is perpendicular to the first direction and the second direction.

In some embodiments, an end of each sliding channel away from the hot filaments is referred to as a first end, and an end of the sliding channel close to the hot filaments is referred to as a second end, first distances between all adjacent sliding channels at the first end are equal to each other, the second distances between all adjacent sliding channels at the second end are equal to each other, and the second distance is greater than the first distance; along a direction from the first end to the second end, distances between adjacent sliding channels gradually transition from the first distance to the second distance.

In some embodiments, one of the sliding channels located at a center of them or near the center is referred to as a first sliding channel, an extension direction of the first sliding channel is parallel to the first direction, remaining sliding channels located at both sides of the first sliding channel are referred to as second sliding channels, the second sliding channels are symmetrically distributed about the first sliding channel, and along a direction away from the first sliding channel, included angles between the second sliding channels and the first direction increase in turn.

In some embodiments, the second sliding channels are linear sliding channels or curved sliding channels.

In some embodiments, each curved sliding channel comprises a first segment and a second segment, the first segment is a straight line segment, and the second segment is a curved line segment.

In some embodiments, the first metal rod, the second metal rod, the first metal blocks and the second metal blocks are made of same material as the hot filaments, and the first metal rod and the second metal rod are configured for electrical connection to an electrode assembly.

The second aspect of the present application provides an apparatus for depositing diamond with automatic control of distance between filaments, comprising a deposition chamber, a control system, a temperature measurement system, an electrode assembly and at least one hot filament structure as described above; the hot filaments and the support assembly are arranged in the deposition chamber, and a portion of the adjustment mechanism is arranged in the deposition chamber; the control system is electrically connected to the temperature measurement system, and the control system is electrically connected to the adjustment mechanism; a portion of the electrode assembly is arranged in the deposition chamber, and is electrically connected to the first metal rod and the second metal rod respectively.

In some embodiments, the adjustment mechanism comprises: a drive assembly; a movable member provided with a plurality of sliding channels, one end of the movable member being connected to the drive assembly; a plurality of connecting members, corresponding one-to-one to the sliding channels, and one end of each connecting member being inserted into a sliding channel, the other end of the connecting member being respectively connected to a first metal block or a second metal block; the apparatus for depositing diamond with automatic control of distance between filaments comprises: an upper cover; a worktable, the upper cover covering the worktable to form the deposition chamber; a mounting frame, fixed on the worktable, comprising a first bracket and a second bracket, the first metal rod being connected to the first bracket, the second metal rod being connected to the second bracket, the movable member being arranged on the mounting frame, and the drive assembly being located outside the deposition chamber.

The third aspect of the present application provides a method for depositing diamond with automatic control of distance between filaments, the method is applied by using the apparatus for depositing diamond with automatic control of distance between filaments described above, and the method at least comprises the following steps:
placing a substrate under the hot filaments in the deposition chamber;
adjusting an initial distance between adjacent hot filaments to 4mm-10mm via the adjustment mechanism;
evacuating the deposition chamber, and simultaneously introducing hydrogen (H₂) with a flow rate of 2000ml/min-4000ml/min, until the pressure in a deposition chamber is constant;
introducing methane (CH₄) to the deposition chamber (400), wherein the methane accounts for 2%-5% of volume of a mixed gas of methane and hydrogen, and maintaining the pressure in the deposition chamber at 6000Pa-8000Pa;
energizing the electrode assembly to heat the hot filaments, and keeping a temperature of the hot filaments at 1500 °C-2000 °C by the control system;
when the temperature of the hot filaments rises to 1500 °C-2000 °C, detecting by the temperature measurement system a temperature of a surface of the substrate in real time and feeding it back to the control system. If the temperature meets a set temperature in the control system, adjusting the flow rate of the hydrogen to 4000ml/min-8000ml/min and depositing diamond on the surface of the substrate;
as a thickness of the deposited diamond continuously increases, detecting by the temperature measurement system a temperature of a surface of the diamond in real time and feeding it back to the control system. Comparing by the control system the detected temperature of the surface of the diamond with a temperature set in a program. If a difference between the detected temperature of the surface of the diamond and the temperature set in the program exceeds a preset threshold, controlling by the control system the adjustment mechanism to adjust a distance between the hot filaments. Detecting by the temperature measurement system the temperature of the surface of the diamond again, until the difference between the detected temperature of the surface of the diamond surface and the temperature set in the program falls within the preset threshold;
when deposition time reaches a set value, controlling by the control system a temperature in the deposition chamber to decrease to a room temperature at a set rate. Beneficial effects of the embodiments of the present application:
   The hot filament structure, apparatus and method for depositing diamond with automatic control of distance between filaments provided by the embodiments of the present application achieve the purpose of adjusting the distance between adjacent hot filaments by setting an adjustment mechanism adjusting the distance between adjacent first metal blocks and adjacent second metal blocks. In this way, as the thickness of the deposited diamond film increases, the distance between adjacent hot filaments increases. By increasing the distance between adjacent hot filaments, the temperature between adjacent hot filaments can be reduced, the excessively high temperature on the surface of the diamond film caused by the increase in the thickness of the diamond film is decreased, which maintains a sufficient nucleation rate, reduces a crystal growth rate, and ensures the uniformity of grain size. In addition, the increase in the distance between hot filaments increases contributes to reducing the radiant heat between adjacent hot filaments, lowering the temperature of the hot filaments, reducing the risk of carbonization on the surface of the hot filaments, and further reducing the risk of hot filament adhesion or even fracture.

### Brief Description of the Drawings

The accompanying drawings described herein are provided for further understanding of the present application and form a part of the present application. The schematic embodiments and descriptions of which are used to explain the present application and do not constitute an improper limitation of the present application.
Fig. 1 is a schematic diagram of the simplified structure of an apparatus for depositing diamond with automatic control of distance between filaments provided by embodiments of the present application;
Fig. 2 is a schematic diagram of the partial structure of the apparatus for depositing diamond with automatic control of distance between filaments in an embodiment provided by embodiments of the present application;
Fig. 3 is a top view of a hot filament structure in an embodiment provided by embodiments of the present application;
Fig. 4a is a bottom view of the hot filament structure in an embodiment provided by embodiments of the present application in a first state;
Fig. 4b is a bottom view of the hot filament structure in an embodiment provided by embodiments of the present application in a second state;
Fig. 5 is a schematic diagram of the structural of the movable member of the system according to embodiments of the present application in an embodiment;
Fig. 6 is a schematic diagram of the structural of the movable member and the connecting member of the system according to embodiments of the present application in an embodiment.

Reference signs:
hot filament structure 100; hot filament 110; support assembly 120; first metal rod 121; second metal rod 122; first metal block 123; second metal block 124; adjustment mechanism 130; movable member 131; sliding channel 1311; first end 1311a; second end 1311b; first sliding channel 13111; second sliding channel 13112; first segment 131121; second segment 131122; connecting member 132; drive assembly 133; control system 200; temperature measurement system 300; deposition chamber 400; upper cover 410; worktable 420; electrode assembly 500; first electrode 510; second electrode 520; gas injection pipeline 600; gas injection hole 610; gas source 700; substrate 800; first distance L1; second distance L2.

### Detailed Description

To clarify the objectives, technical solutions, and advantages of the present invention, the present invention will be further described in detail with reference to the accompanying drawings and embodiments. Obviously, the described embodiments are only a part of the embodiments of the present invention, rather than all of them. Based on the embodiments of the present invention, all other embodiments obtained by those of ordinary skilled in the art fall within the protection scope of the present invention.

In the process of preparing diamond films using the hot filament chemical vapor deposition method, as the thickness of the diamond film increases, the distance between the surface of the diamond film and the hot filament 110 gradually decreases, the temperature of the surface of the diamond increases, the undercooling degree decreases, which leads to a decrease in nucleation rate, an increase in growth rate, and a gradual increase in grain size, resulting in uneven grain sizes at different thickness positions of the finally formed diamond film, which seriously affects the quality of the diamond film.

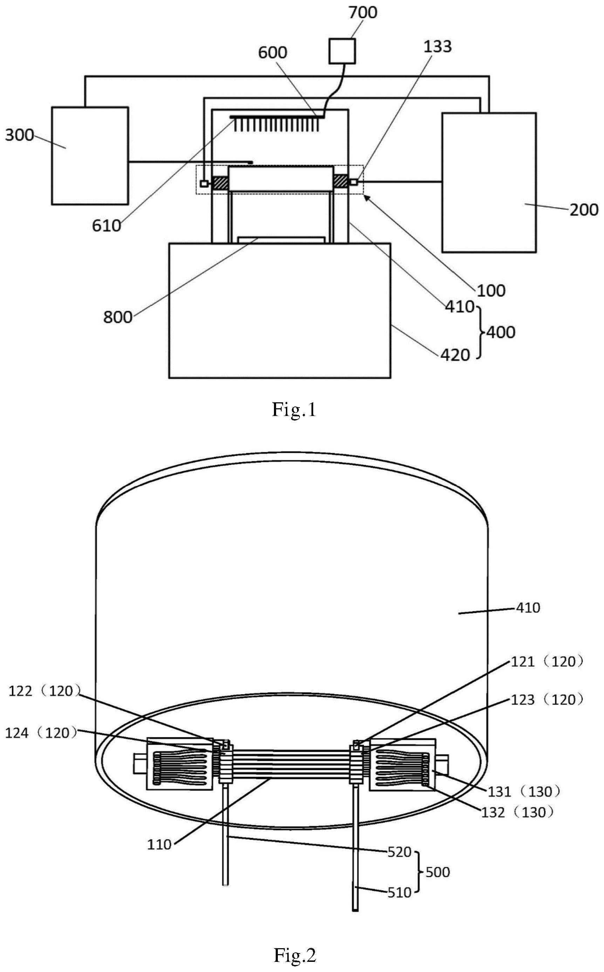

To solve the above technical problem, as shown in Figs. 1 and 2, an embodiment of the present application provides a hot filament structure 100, which includes: a plurality of hot filaments 110, a support assembly 120 and at least one adjustment mechanism 130. The support assembly 120 comprises a first metal rod 121 and a second metal rod 122 disposed oppositely to each other along an extension direction of the hot filaments 110, and a plurality of first metal blocks 123 slidably disposed at the first metal rod 121, a plurality of second metal blocks 124 slidably disposed at the second metal rod 122, one end of the hot filaments 110 is connected to the first metal blocks 123 one to one, and the other end of the hot filaments 110 is connected to the second metal block 124 one to one. The adjustment mechanism 130 is connected to the first metal blocks 123 and the second metal blocks 124 to adjust a distance between adjacent hot filaments 110.

In the embodiment of the present application, the adjustment mechanism 130 is set to adjust a distance between adjacent first metal blocks 123 and a distance between adjacent second metal blocks 124, thereby achieving the purpose of adjusting the distance between adjacent hot filaments 110. In this way, as the thickness of the deposited diamond film increases, the distance between adjacent hot filaments 110 increases. By increasing the distance between adjacent hot filaments 110, the temperature between adjacent hot filaments 110 can be reduced, the excessively high temperature on the surface of the diamond film caused by the increase in the thickness of the diamond film is decreased, which maintains a sufficient nucleation rate, reduces a crystal growth rate, and ensures the uniformity of grain size. In addition, the increase in the distance between hot filaments 110 contributes to reducing the radiant heat between adjacent hot filaments 110, lowering the temperature of the hot filaments 110, reducing the risk of carbonization on the surface of the hot filaments 110, and further reducing the risk of hot filament 110 adhesion or even fracture.

The support assembly 120 is made of metal, so the metal rod can be electrically connected to electrodes to achieve electrical connection to the hot filaments 110. In this way, the support assembly 120 can be used for both support and electrical connection, which simplifies the structure of the hot filament structure 100.

Optionally, the hot filaments 110 are arranged parallel to each other.

In some embodiments of the present application, there may be one adjustment mechanism 130. In this case, both the positions of the first metal blocks 123 and the positions of the second metal blocks 124 are adjusted by the same adjustment mechanism 130. By driving the first metal blocks 123 and the second metal blocks 124, the distance between the hot filaments 110 can be adjusted.

In some embodiments of the present application, as shown in Figs. 1 and 2, the hot filament structure 100 comprises two adjustment mechanisms 130, which are arranged at intervals along the extension direction of the hot filaments 110, and are respectively arranged at the outer sides of the first metal rod 121 and the second metal rod 122. The adjustment mechanisms 130 are respectively connected to the first metal blocks 123 and the second metal blocks 124.

In this embodiment, the adjustment mechanisms 130 are respectively arranged at the outer sides of the first metal rod 121 and the second metal rod 122, where the outer sides can be understood as: sides of the first metal rod 121 and the second metal rod 122 away from the hot filaments 110 along the extension direction of the hot filaments 110. Each adjustment mechanism 130 is used to adjust the position of the metal blocks close to itself. Setting two adjustment mechanisms 130 can simplify the structure of the adjustment mechanism 130.

In some embodiments of the present application, as shown in Figs. 1, 3, and 4a, 4b, the adjustment mechanism 130 comprises: a drive assembly 133, a movable member 131 and a plurality of connecting members 132. The movable member 131 is provided with a plurality of sliding channels 1311, and one end of the movable member 131 is connected to the drive assembly 133. The plurality of connecting members 132 correspond one-to-one to the sliding channels 1311, and one ends of the connecting members 132 are inserted into the sliding channels 1311, the other ends of the connecting members 132 are respectively connected to the first metal blocks 123 or the second metal blocks 124 one-to-one. The drive assembly 133 is used to drive the movable member 131 to move along a first direction, so that the movable member 131 slides relative to the connecting members 132 along the sliding channel 1311, thus the connecting member 132 can be driven to move along a second direction to drive the hot filaments 110 to move along the second direction, wherein the first direction is parallel to the extension direction of the hot filaments 110, and the second direction is co-planar with and perpendicular to the first direction.

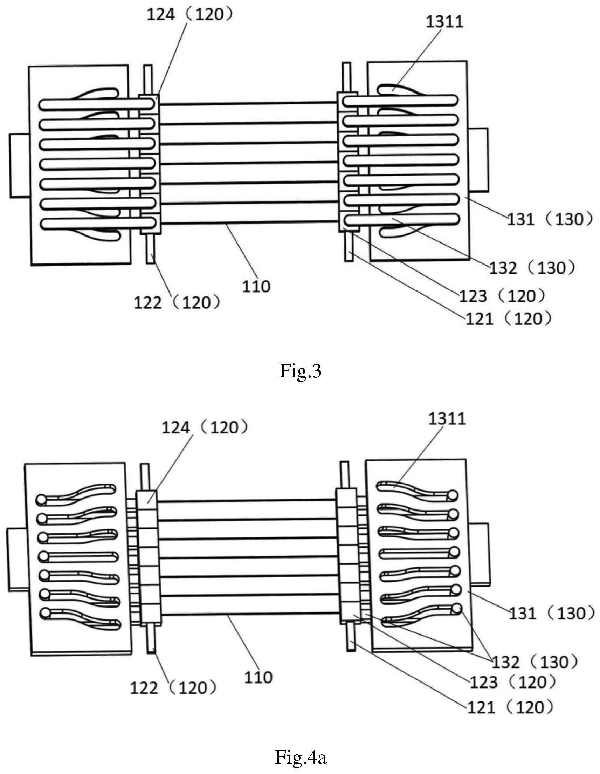

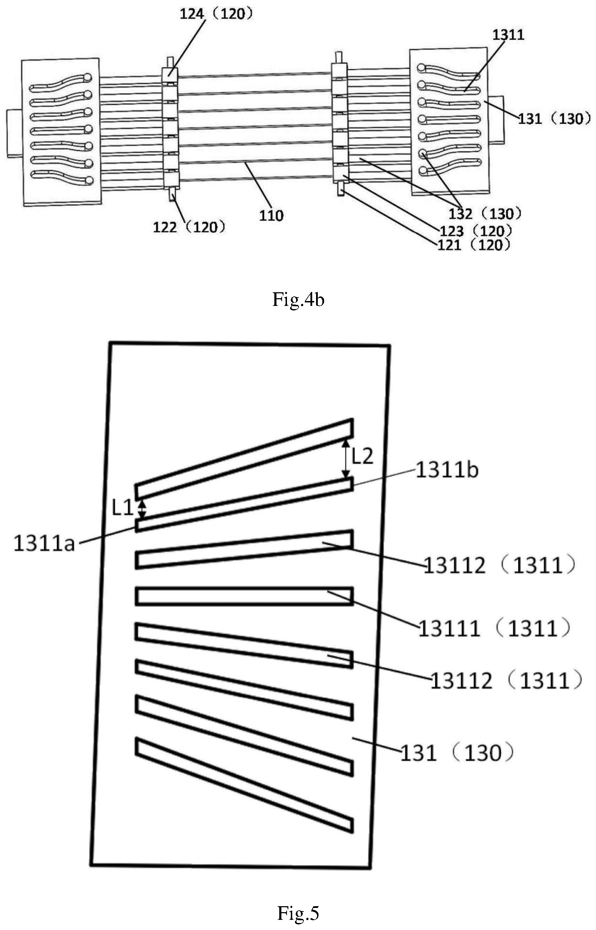

In this embodiment, the drive assembly 133 is used to drive the movable member 131 to move along the first direction, that is, the extension direction of the hot filament 110. Since one ends of the connecting members 132 are inserted into the sliding channels 1311 of the movable member 131, when the movable member 131 slides relative to the sliding channel 1311, the ends of the connecting members 132 inserted into the sliding channels 1311 can move in the second direction, that is, in the lateral direction perpendicular to the extension direction of the hot filaments, according to the change in the shape of the sliding channels 1311. Comparing Fig. 4a and Fig. 4b, it can be seen that through the movement of the movable member 131, the distance between the hot filaments 110 changes. The distance between the hot filaments 110 in Fig. 4b is slightly increased compared to that in Fig. 4a. In this way, the metal blocks connected to the connecting member 132 will also move laterally under the action of the connecting member 132, thereby achieving the purpose of changing the distance between adjacent hot filaments 110.

There are two movable members 131, and each of the movable members 131 is driven by a drive assembly 133 respectively, that is, two drive assemblies 133 may be arranged, the two drive are respectively located on both sides of the upper cover (described later) 410, arranged in correspondence to the movable members 131. The drive assemblies 133 are connected to the movable members 131 through intermediate connecting members (not shown in the figure).

It should be noted that when there is only one adjustment mechanism 130, the adjustment mechanism 130 comprises a movable member 131 and a drive assembly 133, the connecting members 132 need to connect the first metal blocks 123 and the second metal blocks 124 simultaneously. The connecting member 132 can be a special-shaped structure to avoid the position corresponding to the hot filament 110, to reduce the impact on the temperature field around the hot filament 110. For example, the connecting member 132 comprises a first horizontal segment connected to the first metal blocks 123, the end of the first horizontal segment is connected in turn to a first vertical segment, a second horizontal segment, a second vertical segment. The end of the second vertical segment is connected to the second metal blocks 124. The length of the second horizontal segment is approximately equal to the length of the hot filaments 110. Of course, a third horizontal segment can also be arranged at the end of the second vertical segment, and the third horizontal segment is used to connect to the second metal blocks 124.

Optionally, the drive assembly 133 can be a lead screw motor, or a combination structure of a motor and a transmission assembly, such as a combination of a motor and a synchronous belt, a combination of a motor and a gear-rack, etc. Taking the lead screw motor as an example, the movable member 131 is connected to the nut of the lead screw motor. When the screw of the lead screw motor rotates forward or reverse, the nut is driven to move in a direction away from the first metal rod 121 or the second metal rod 122, or in a direction close to the first metal rod 121 or the second metal rod 122, so that the hot filaments 110 move close to each other or away from each other. The movable member 131 can be connected to the nut through an intermediate connecting member. The intermediate connecting member can be a connecting plate, a connecting rod, etc., which can rigidly connects the movable member 131 and the nut.

Wherein, the sliding channels 1311 may extend through or do not extend through the movable member 131 along a thickness direction of the movable member 131, and the thickness direction is perpendicular to the first direction and the second direction.

When the sliding channels 1311 extend through the movable member 131 along the thickness direction, that is, the sliding channels 1311 are through-hole type sliding channels 1311, in this way, the connecting members 132 can be inserted deeper, which improves the reliability of the connection between the connecting members 132 and the movable member 131. Moreover, during the sliding process of the connecting member 132 relative to the movable member 131, the bottom of the connecting member 132 does not contact the movable member 131, which can also reduce sliding friction.

When the sliding channel 1311 does not extend through the movable member 131 along the thickness direction, that is, the sliding channel 1311 is a groove-type sliding channel 1311. The sliding channel 1311 not penetrating the movable member 131 is beneficial to improve the continuing strength of the movable member 131 and extend the service life of the movable member 131.

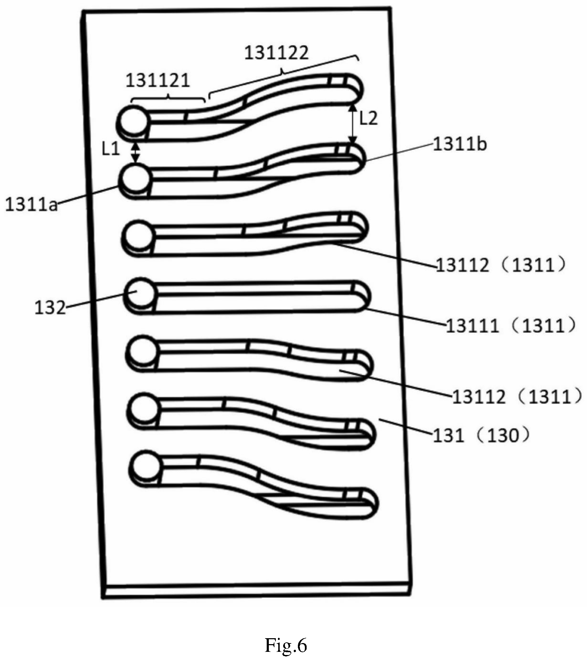

In order to change the distance between adjacent hot filaments 110, the sliding channels 1311 in the movable member 131 satisfy the following conditions: the ends of the sliding channels 1311 away from the hot filaments 110 are the first end 1311a, and the ends close to the hot filaments 110 are the second end 1311b. The first distances L1 between adjacent sliding channels 1311 at the first end 1311a are equal, the second distances L2 between adjacent sliding channels 1311 at the second end 1311b are equal, and the second distance L2 is greater than the first distance L1. Along the direction from the first end 1311a to the second end 1311b, distances between adjacent sliding channels gradually transition from the first distance L1 to the second distance L2, as shown in Figs. 5 and 6.

It should be noted that when the distance between the first ends 1311a of two adjacent sliding channels 1311 is the first distance L1, the initial position of the connecting member 132 is located at the first end 1311a, and the movable member 131 moves in the direction away from the hot filament 110. Of course, the second distance L2 can also be shorter than the first distance L1, in this case the initial position of the connecting member 132 is located at the second end 1311b, and the movable member 131 moves in the direction close to the hot filament 110. Both of the above methods fall within the protection scope of the present application.

The second distance L2 is greater than the first distance L1 as an example for illustration herein. As shown in Figs. 5 and 6, when the movable member 131 moves from a location near the hot filament 110 to a location away from the hot filament 110 relative to the connecting member 132, the connecting member 132 moves from the first end 1311a to the second end 1311b of the sliding channel 1311. Since the distance between the sliding channels 1311 at the second end 1311b is longer than that at the first end 1311a, when the connecting member 132 moves to the second end 1311b, the distance between adjacent connecting members 132 increases, and the distance between adjacent first metal blocks 123 and the distance between adjacent second metal blocks 124 connected to the connecting members 132 naturally increase, and thus the distance between adjacent hot filaments 110 connected to the first metal blocks 123 and the second metal blocks 124 also increases.

As a feasible embodiment, as shown in Figs. 5 and 6, one of the sliding channels 1311 located at a center of them or near the center is referred to as a first sliding channel 13111, the extension direction of the first sliding channel 13111 is parallel to the first direction, the remaining sliding channels 1311 located at both sides of the first sliding channel 13111 are referred to as second sliding channels 13112, the second sliding channels are symmetrically distributed about the first sliding channel 13111. Along the direction away from the first sliding channel 13111, included angles between the second sliding channels 13112 and the first direction increase in turn.

Wherein, the number of sliding channels 1311 can be odd or even. When the number is odd, as shown in Fig. 6, the first sliding channel 13111 is one of the sliding channels 1311 located at the center. When the number is even, as shown in Fig. 5, the first sliding channel 13111 is one of the sliding channels 1311 near the center. The remaining sliding channels 1311 located at both sides of the first sliding channel 13111 are the second sliding channels 13112, the second sliding channels 13112 are symmetrically distributed about the first sliding channel 13111. Along the direction away from the first sliding channel 13111, the included angles between the second sliding channels 13112 and the first direction increase in turn, which means that the farther a second sliding channel 13112 is from the first sliding channel 13111, the larger the included angle between the second sliding channel 13112 and the first direction. In this way, the distances between adjacent hot filaments 110 are all increased after adjustment by the adjustment mechanism 130, and the increased distances are equal.

Optionally, as shown in Figs. 5 and 6, the second sliding channels 13112 can be linear sliding channels or curved sliding channels.

The second sliding channel 13112 being linear sliding channels has an advantage of a simple structure. The included angle between the second sliding channel 13112 and the first direction is an acute angle, and its variation range can be 15 °-60 °. If the included angle is too small, for example, less than 15 °, the change in the distance between the hot filaments 110 is small, which has little impact on the surrounding temperature field, and on the grain size. If the included angle is too large, for example, greater than 60 °, the relative sliding between the movable member 131 and the connecting member 132 becomes difficult due to the large change in angle, which is likely to lead to wear between them.

Of course, the sliding channels 1311 can also be curved sliding channels. The curved sliding channels make the movable members 131 slide more smoothly relative to the connecting members 132, and the arrangement space of the movable member 131 can be reasonably utilized, and more sliding channels 1311 can be arranged in the same arrangement space.

The curved sliding channels can be arc-shaped sliding channels with a constant radius of curvature, or curved sliding channels with inflection points. For example, the shape of the sliding channels 1311 can be similar to the geometric image of the function Y=X³ on [0, +∞] or similar to the geometric image of the function Y=X³ on [-∞, 0].

Of course, the curved sliding channels can also be set in segments, as shown in Fig. 6, a curved sliding channel comprises a first segment 131121 and a second segment 131122, where the first segment 131121 is a straight segment, and the second segment 131122 is a curved segment.

In some embodiments of the present application, the first metal rod 121, the second metal rod 122, the first metal blocks 123 and the second metal blocks 124 are made of the same material as the hot filaments 110, and the first metal rod 121 and the second metal rod 122 are used for electrical connection to the electrode assembly 500.

The electrode assembly 500 comprises a first electrode 510 and a second electrode 520, wherein the first electrode 510 can be a positive electrode or a negative electrode, and the second electrode 520 can be a negative electrode or a positive electrode. The first metal rod 121 is electrically connected to the first electrode 510, and the second metal rod 122 is electrically connected to the second electrode 520, so that both ends of the hot filaments 110 are electrically connected to the positive electrode and the negative electrode respectively. The first metal rod 121, the second metal rod 122, the first metal blocks 123 and the second metal blocks 124 are made of the same material as the hot filaments 110, which can reduce the contact resistance between the first metal rod 121 and the first metal blocks 123 and between the first metal blocks 123 and the hot filaments 110, as well as between the second metal rod 122 and the second metal blocks 124, and between the second metal blocks 124 and the hot filaments 110. This is because the resistivity of the same material is lower, and the contact resistance will also be reduced correspondingly. In addition, the contact surfaces made of the same material are easier to achieve tight contact, which reduces the contact resistance, and is beneficial for improving the utilization rate of electric energy.

Optionally, the hot filaments 110 can be tantalum filaments. Metallic tantalum has an extremely high melting point, up to 2996 °C, which enables the tantalum filaments to maintain stable performance in high-temperature environments and not easy to melt or deform. Of course, in some embodiments, the hot filament 110 can also be made of tungsten filament, molybdenum filament, etc., all of which are applicable to the hot filament structure 100 provided by the embodiments of the present application.

Of course, the first metal rod 121, the second metal rod 122, the first metal blocks 123 and the second metal blocks 124 can also be made of similar materials to the heating wires 110. The metal rods and metal blocks are made of similar materials to the hot filaments 110, which is also beneficial to reduce the contact resistance there between.

The second aspect of the embodiments of the present application provides an apparatus for depositing diamond with automatic control of distance between filaments. As shown in Figs. 1 and 2, the apparatus for depositing diamond with automatic control of distance between filaments comprises a deposition chamber 400, a control system 200, a temperature measurement system 300, at least two electrode assemblies 500 and at least one hot filament structure 100 as described above; the hot filaments 110 and the support assembly 120 are arranged in the deposition chamber 400, and a portion of the adjustment mechanism 130 is arranged in the deposition chamber 400; the control system 200 is electrically connected to the temperature measurement system 300, and the control system 200 is electrically connected to the adjustment mechanism 130; a portion of the electrode assembly 500 is arranged in the deposition chamber 400, and is connected to the first metal rod 121 and the second metal rod 122 respectively.

The deposition chamber 400 is a reaction chamber for depositing diamond films, which is a closed cavity capable of maintaining the reaction gas atmosphere in the deposition chamber 400. The hot filaments 110 are placed inside the deposition chamber 400 to ensure the stability of the temperature field around the hot filaments 110. During the process of deposition, the change in deposition thickness will lead to superheat of the surface of the deposited film. The temperature measurement system 300 feeds back the temperature of the surface of the deposited film in real time, and the control system 200 controls the adjustment mechanism 130 to adjust the distance between adjacent hot filaments 110 according to the information fed back by the temperature measurement system 300. This reduces the superheat of the surface of the diamond film caused by the decrease in the distance between the diamond film surface and the hot filaments 110, thereby ensuring the nucleation rate on the diamond film surface and reducing the growth rate of the crystal, which keeps the grain size basically consistent with the formed grain size, makes the grain size of the deposited diamond film uniform, and improves the quality of the diamond film. In addition, the distance between the hot filaments 110 is such adjusted through the adjustment mechanism 130 that the distance between the hot filaments 110 increases with the increase of the deposition thickness of the diamond film. This is beneficial to reduce the radiant heat between adjacent hot filaments 110, lower the temperature of the hot filaments 110, thereby reducing the risk of carbonization on the surface of the hot filaments 110, further reducing the risk of adhesion or even fracture of the hot filaments 110, which is beneficial for extending the service life of the hot filament structure 100.

The temperature measurement system 300 can be an infrared temperature measurement system 300, which does not need to contact the surface of the substrate 800 or the surface of the diamond film, has a flexible installation position, and it is convenient for measuring the temperature of the surface of the substrate 800 or the surface of the diamond film. The substrate 800 is a carrier for depositing diamond films, and can be selected from one of Si, graphite, Mo, W, SiO₂, tungsten carbide, silicon carbide, Si₃N₄. For example, the substrate 800 is a Mo sheet.

In some embodiments of the present application, the apparatus for depositing diamond with automatic control of distance between filaments comprises: an upper cover 410, a worktable 420 and a mounting frame. The upper cover 410 covers the worktable 420 to form the deposition chamber 400. The mounting frame is fixed on the worktable 420, and comprises a first bracket and a second bracket. The first metal rod 121 is connected to the first bracket, the second metal rod 122 is connected to the second bracket, the movable member 131 is arranged on the mounting frame, and the drive assembly 133 is located outside the deposition chamber 400.

The upper cover 410 covers the worktable 420 to form a closed deposition chamber 400. During the process of deposition, the deposition chamber 400 is in a reaction gas atmosphere, which prevents air from entering, avoids oxidation of the hot filaments 110 and the surface of the substrate 800, and ensures the progress of the deposition is smooth. The movable member 131 is fixed on the worktable 420 by the mounting frame, which can be made of high-temperature resistant insulating material. The drive assembly 133 is placed outside the deposition chamber 400, in this way, the drive assembly 133 does not need to be designed as a high-temperature resistant component, which can reduce the manufacturing cost of the apparatus for depositing diamond with automatic control of distance between filaments. One end of the movable member 131 can be connected to the drive assembly 133 by means of an intermediate connecting member, the intermediate connecting member passes through the side wall of the upper cover 410 to connect to the drive assembly 133. For example, the drive assembly 133 is a lead screw motor, the lead screw motor comprises a base, a nut, a screw and a motor. The lead screw is mounted on the base, the nut is sleeved on the screw, the nut or the base is provided with a slide rail, and the other is provided with a slide groove, and the nut and the base are connected in a sliding way. When the motor drives the screw to rotate, the nut can move linearly along the screw. The base, nut, lead screw and motor are all located outside the upper cover 410. The movable member 131 is connected to the nut through the intermediate connecting member. In this way, when the lead screw drives the nut to move linearly, the movable member 131 can be driven to move linearly, thereby the distances between the hot filaments 110 can be changed.

It is understandable that the apparatus for depositing diamond with automatic control of distance between filaments comprises a gas injection pipeline 600. The gas injection pipeline 600 can extend into the deposition chamber 400 from the top of the upper cover 410, and is provided with gas injection holes 610 on the side close to the hot filaments 110. The gas in the gas injection pipeline 600 is injected towards the hot filaments 110 through the gas injection holes 610. One end of the gas injection pipeline 600 is connected to a gas source 700. The gas is dissociated and excited after passing through the surface of the hot filaments 110. Taking the deposition of diamond films as an example, the gas source 700 is a carbon source and hydrogen source gas. The gas, after passing through the hot filaments 110, is dissociated into active carbon atom groups and hydrogen ions. The dissociated active carbon atom groups and hydrogen ions reach the surface of the substrate 800 placed on the worktable 420 directly under the hot filaments 110. By controlling the pressure, temperature and hydrogen ion concentration inside the deposition chamber 400, the active carbon atomic groups and hydrogen ions can be recombined and nucleated on the surface of the substrate 800 to form diamond particles, which then grow into diamond films or diamond thick films. The apparatus for depositing diamond with automatic control of distance between filaments further comprises a vacuum extractor, which is used to evacuate the deposition chamber 400 and to ensure the vacuum atmosphere inside the deposition chamber 400.

The third aspect of the embodiments of the present application provides a method for depositing diamond with automatic control of distance between filaments, which is applied by using the apparatus for depositing diamond with automatic control of distance between filaments described above, at least comprising the following steps:
S1: Placing a substrate 800 under the hot filaments 110 in the deposition chamber 400.
S2: Adjusting an initial distance between adjacent hot filaments 110 to 4mm-10mm via the adjustment mechanism 130.
S3: Evacuating the deposition chamber 400 and simultaneously introducing hydrogen with a flow rate of 2000ml/min-4000ml/min, until a pressure in the deposition chamber 400 is constant.
S4: Introducing methane CH₄ to the deposition chamber 400, wherein the methane accounts for 2%-5% of volume of a mixed gas of methane and hydrogen, and maintaining the pressure inside the deposition chamber 400 at 6000Pa-8000Pa.
S5: Energizing the electrode assembly 500 to heat the hot filaments 110, and keeping a temperature of the hot filaments 110 at 1500 °C-2000 °C by the control system 200.
S6: When the temperature of the hot filaments rises to 1500 °C-2000 °C, detecting by the temperature measurement system 300 a temperature of a surface of the substrate 800 in real time and feeding it back to the control system 200. If the temperature meets a set temperature in the control system 200, for example 800 °C-1200 °C, adjusting the flow rate of the hydrogen to 4000ml/min-8000ml/min, and depositing diamond on the surface of the substrate 800.
S7: As a thickness of the deposited diamond continuously increases, detecting by the temperature measurement system 300 a temperature of a surface of the diamond in real time and feeding it back to the control system 200. Comparing by the control system 200 the detected temperature of the surface of the diamond with a temperature set in a program. If a difference between the detected temperature of the surface of the diamond and the temperature set in the program exceeds a preset threshold, for example 50 °C, controlling by the control system 200 the adjustment mechanism 130 to adjust a distance between the hot filaments 110. Detecting by the temperature measurement system 300 the temperature of the surface of the diamond again, until the difference between the detected temperature of the surface of the diamond and the temperature set in the program falls within the preset threshold.
S8: When the deposition time reaches a set value, for example 150 hours-200 hours, controlling by the control system 200 the temperature inside the deposition chamber 400 to decrease to room temperature at a set rate.

The temperature of the surface of the deposited diamond film in real time is detecting by the temperature measurement system 300, and the detected surface temperature with the temperature set in the program is compared, when the difference between the detected temperature of the surface and the temperature set in the program exceeds a preset threshold, for example 50 °C, the control system 200 controls the adjustment mechanism 130 to adjust the distance between the hot filaments 110. Since the diamond film is getting closer and closer to the hot filaments 110, the temperature of the diamond surface is generally higher than the temperature set in the program. Therefore, the distance between the hot filaments 110 can be increased by the adjustment mechanism 130 to achieve the purpose of reducing the temperature of the diamond surface. That is to say, during the deposition process, the initial distance between the hot filaments 110 is a minimum value, that is, the connecting members 132 are located at the first end 1311a of the sliding channels 1311, so that the distance between the hot filaments 110 has a larger adjustable space when it is adjusted by the adjustment mechanism 130 during the deposition process. Of course, according to the actual situation, the initial distance between the hot filaments 110 can also be an intermediate value, that is, the connecting members 132 are at the middle position of the sliding channels 1311, so that distance between the hot filaments 110 can be increased or decreased through the adjustment mechanism 130. Since this method can keep the temperature of the surface of the substrate 800 and the diamond within the program temperature range at all times, it can ensure the uniform size of the grain of the deposited diamond film and improve the quality of the diamond film.

It should be noted that step S2 can be performed before S1, or after S1, or after S3, or even after S4, which is not limited in the present application.

It should be noted that in this article, relational terms such as first and second are only to distinguish one entity or operation from another entity or operation, and do not necessarily require or imply any actual relationship or order between these entities or operations. Moreover, the terms "include", "comprise", or any other variation thereof are intended to encompass a non-exclusive inclusion, such that a process, method, article, or device that includes a series of elements not only include those elements, but also other elements that are not explicitly listed, or further include elements inherent in such a process, method, article, or device. Without further limitations, the elements limited by the statement "including one..." do not exclude the existence of other identical elements in the process, method, article, or device that includes these elements.

The various embodiments in this specification are described in a relevant manner, and the same and similar parts among these embodiments can be referred to each other, and each embodiment focuses on the differences from other embodiments.

The above description is only preferred embodiments of the present invention, and is not intended to limit the scope of the invention. Any modification, equivalent replacements, improvements, etc. made within the spirit and principles of the invention shall be included within the protection scope of the present invention.

## Claims

1. A hot filament structure, comprising:
a plurality of hot filaments (110);
a support assembly (120), comprising a first metal rod (121) and a second metal rod (122) arranged opposite to each other along an extension direction of the hot filaments (110), a plurality of first metal blocks (123) slidably arranged at the first metal rod (121), and a plurality of second metal blocks (124) slidably arranged at the second metal rod (122), one end of each hot filament (110) is connected to a first metal block (123), and the other end of the hot filament (110) is connected to a second metal block (124);
at least one adjustment mechanism (130) connected to the first metal blocks (123) and the second metal blocks (124) to adjust a distance between adjacent hot filaments (110).

2. The hot filament structure according to claim 1, wherein the hot filament structure (100) comprises two adjustment mechanisms (130) arranged at intervals along the extension direction of the hot filaments (110), and respectively arranged at outer sides of the first metal rod (121) and the second metal rod (122), and the adjustment mechanisms (130) are respectively connected to the first metal blocks (123) and the second metal blocks (124).

3. The hot filament structure according to claim 2, wherein the adjustment mechanism (130) comprises:
a drive assembly (133);
a movable member (131) provided with a plurality of sliding channels (1311), one end of the movable member (131) being connected to the drive assembly (133);
a plurality of connecting members (132), corresponding one-to-one to the sliding channels (1311), and one end of each connecting member (132) being inserted into a sliding channel (1311), the other end of the connecting member (132) being respectively connected to a first metal block (123) or a second metal block(124);
the drive assembly (133) is configured for driving the movable member (131) to move along a first direction, such that the movable member (131) slides relative to the connecting members (132) along the sliding channels (1311), thus the connecting members (132) can be driven to move along a second direction to drive the hot filaments (110) to move along the second direction, wherein the first direction is parallel to the extension direction of the hot filaments (110), and the second direction is co-planar with and perpendicular to the first direction.

4. The hot filament structure according to claim 3, wherein the sliding channels (1311) extend through or do not extend through the movable member (131) along a thickness direction of the movable member (131), and the thickness direction is perpendicular to the first direction and the second direction.

5. The hot filament structure according to claim 3, wherein an end of each sliding channel (1311) away from the hot filaments (110) is referred to as a first end (1311a), and an end of the sliding channel close to the hot filaments (110) is referred to as a second end (1311b), first distances (L1) between all adjacent sliding channels (1311) at the first end (1311a) are equal to each other, second distances (L2) between all the adjacent sliding channels (1311) at the second end (1311b) are equal to each other, and the second distance (L2) is greater than the first distance (L1); along a direction from the first end (1311a) to the second end (1311b), distances between adjacent sliding channels (1311) gradually transition from the first distance (L1) to the second distance (L2).

6. The hot filament structure according to claim 5, wherein one of the sliding channels (1311) located at a center of them or near the center is referred to as a first sliding channel (13111), an extension direction of the first sliding channel (13111) is parallel to the first direction, remaining sliding channels (1311) located at both sides of the first sliding channel (13111) are referred to as second sliding channels (13112), the second sliding channels (13112) are symmetrically distributed about the first sliding channel (13111), and along a direction away from the first sliding channel (13111), included angles between the second sliding channels (13112) and the first direction increase in turn.

7. The hot filament structure according to claim 6, wherein the second sliding channels (13112) are linear sliding channels or curved sliding channels.

8. The hot filament structure according to claim 7, wherein each curved sliding channel comprises a first segment (131121) and a second segment (131122), the first segment (131121) is a straight line segment, and the second segment (131122) is a curved line segment.

9. The hot filament structure according to claim 3, wherein the first metal rod (121), the second metal rod (122), the first metal blocks (123) and the second metal blocks (124) are made of same material as the hot filaments (110), and the first metal rod (121) and the second metal rod (122) are configured for electrical connection to an electrode assembly (500).

10. An apparatus for depositing diamond with automatic control of distance between filaments, wherein the apparatus comprises a deposition chamber (400), a control system (200), a temperature measurement system (300), an electrode assembly (500), and at least one hot filament structure (100) as claimed in any one of claims 1-9;
the hot filaments (110) and the support assembly (120) are arranged in the deposition chamber (400), and a portion of the adjustment mechanism (130) is arranged in the deposition chamber (400);
the control system (200) is electrically connected to the temperature measurement system (300), and the control system (200) is electrically connected to the adjustment mechanism (130);
a portion of the electrode assembly (500) is arranged in the deposition chamber (400), and is electrically connected to the first metal rod (121) and the second metal rod (122) respectively.

11. The apparatus for depositing diamond with automatic control of distance between filaments according to claim 10, wherein the adjustment mechanism (130) comprises:
a drive assembly (133);
a movable member (131) provided with a plurality of sliding channels (1311), one end of the movable member (131) being connected to the drive assembly (133);
a plurality of connecting members (132), corresponding one-to-one to the sliding channels (1311), and one end of each connecting member (132) being inserted into a sliding channel (1311), the other end of the connecting member (132) being respectively connected to a first metal block (123) or a second metal block (124);
the apparatus for depositing diamond with automatic control of distance between filaments comprises:
an upper cover (410);
a worktable (420), the upper cover (410) covering the worktable (420) to form the deposition chamber (400);
a mounting frame, fixed on the worktable (420), comprising a first bracket and a second bracket, the first metal rod (121) being connected to the first bracket, the second metal rod (122) being connected to the second bracket, the movable member (131) being mounted on the mounting frame, and the drive assembly (133) being arranged outside the deposition chamber (400).

12. A method for depositing diamond with automatic control of distance between filaments, **characterized in that** the method is applied by using the apparatus for depositing diamond with automatic control of distance between filaments according to claim 10 or 11, and the method at least comprises the following steps:
placing a substrate (800) under the hot filaments (110) in the deposition chamber (400);
adjusting an initial distance between adjacent hot filaments (110) to 4mm-10mm via the adjustment mechanism (130);
evacuating the deposition chamber (400), and simultaneously introducing hydrogen with a flow rate of 2000ml/min-4000ml/min, until a pressure in the deposition chamber (400) is constant;
introducing methane (CH₄) to the deposition chamber (400), wherein the methane accounts for 2%-5% of volume of a mixed gas of methane and hydrogen, and maintaining the pressure in the deposition chamber (400) at 6000Pa-8000Pa;
energizing the electrode assembly (500) to heat the hot filaments (110), and keeping a temperature of the hot filaments (110) at 1500 °C-2000 °C by the control system (200);
when the temperature of the hot filaments (110) rises to 1500 °C-2000 °C, detecting by the temperature measurement system (300) a temperature of a surface of the substrate (800) in real time and feeding it back to the control system (200); in response to determining that the temperature meets a set temperature in the control system (200), adjusting the flow rate of the hydrogen to 4000ml/min-8000ml/min and depositing diamond on the surface of the substrate (800);
as a thickness of the deposited diamond continuously increases, detecting by the temperature measurement system (300) a temperature of a surface of the diamond in real time and feeding it back to the control system (200); comparing by the control system (200) the detected temperature of the surface of the diamond with a temperature set in a program; in response to determining that a difference between the detected temperature of the surface of the diamond and the temperature set in the program exceeds a preset threshold, controlling by the control system (200) the adjustment mechanism (130) to adjust a distance between the hot filaments (110); detecting by the temperature measurement system (300) the temperature of the surface of the diamond again, until the difference between the detected temperature of the surface of the diamond and the temperature set in the program falls within the preset threshold;
when deposition time reaches a set value, controlling by the control system (200) a temperature in the deposition chamber (400) to decrease to a room temperature at a set rate.
